Europäisches Patentamt

European Patent Office

Office européen des brevets

(11) Veröffentlichungsnummer: **0 262 559**
**A1**

(12) **EUROPÄISCHE PATENTANMELDUNG**

(21) Anmeldenummer: 87113838.4

(22) Anmeldetag: 22.09.87

(51) Int. Cl.⁴: **G06F 11/26 , G01R 31/28**

(30) Priorität: 01.10.86 DE 3633464

(43) Veröffentlichungstag der Anmeldung:
06.04.88 Patentblatt 88/14

(84) Benannte Vertragsstaaten:
AT BE CH DE ES FR GB IT LI SE

(71) Anmelder: **Siemens Aktiengesellschaft Berlin
und München**
**Wittelsbacherplatz 2**
**D-8000 München 2(DE)**

(72) Erfinder: **Unger, Jürgen, Dipl.-Ing. (FH)**
**Murgstrasse 10**
**D-7514 Eggenstein(DE)**
Erfinder: **Wöstenkühler, Gerd, Dipl.-Ing.**
**Röntgenstrasse 18**
**D-6744 Kandel(DE)**

(54) **Prüfsystem für digitale Schaltungen.**

㊼ Prüfsystem für digitale Schaltungen, bei dem Prüfdatensätze für die Bausteine und weitere Datensätze für die nach einem vorgegebenen Übertragungsverfahren arbeitenden Busleitungen der digitalen Schaltung (P) bereitgestellt werden und ein Vergleich der Antwortdatensätze der Bausteine mit entsprechenden Referenzdatensätzen vorgenommen wird. Um eine bus-und bausteinspezifische Prüfung der digitalen Schaltung zu ermöglichen, werden die Prüfdatensätze und entsprechende Steuersignale für die Prüfsequenzen getrennt gespeichert und jeweils busspezifisch kombiniert.

Die Erfindung ist vor allem bei digitalen Schaltungen mit unterschiedlichen Prozessoren anwendbar.

EP 0 262 559 A1

## Prüfsystem für digitale Schaltungen

Die Erfindung bezieht sich auf ein Prüfsystem für digitale Schaltungen, bei dem Prüfdatensätze für die Bausteine und weitere Datensätze für die nach einem vorgegebenen Übertragungsverfahren arbeitenden Busleitungen der digitalen Schaltung bereitgestellt werden und ein Vergleich der Antwortdatensätze der Bausteine mit entsprechenden Referenzdatensätzen vorgenommen wird.

Besonders bei busorientierten digitalen Schaltungen müssen zur Qualitätssicherung die am Bus befindlichen Bausteine getestet werden, wobei eingebettete Speicherbausteine bezüglich der Prüfdatenmenge ein zusätzliches Problem darstellen. Die Prüfung der Bausteine erfolgt durch Stimulieren mit geeigneten Prüfdatensätzen und Vergleichen der Bausteinantworten mit Referenzdatensätzen. Anlegen und Abfragen der Signale muß nach der Spezifikation des jeweiligen Busses erfolgen, wodurch selbst bei gleichen Bausteinen unterschiedliche Prüfsequenzen notwendig werden können. Das bedeutet, daß für jede Bus-Bausteinkombination ein spezieller Prüfdatensatz bereitgestellt werden muß. Somit ist die Anzahl der Prüfdatensätze gleich der Anzahl der Busse mal Anzahl der Bausteine in den zu prüfenden digitalen Schaltungen.

Zur Nachbildung des Busprotokolls werden bisher in der Regel universell verwendbare digitale Prüfsysteme bzw. prozessororientierte Prüfsysteme eingesetzt. Diese digitalen Prüfsysteme erfüllen nur bedingt die Zeitanforderungen des Busses. Die Programmierung ist aufwendig, die dabei entstehende Datenmenge groß. Bei Verwendung eines prozessororientierten Prüfsystems muß für jeden Prozessor ein eigener Prüfmodul erstellt werden. Er enthält im wesentlichen den gleichen Prozessor wie der Prüfling.

Der Erfindung liegt die Aufgabe zugrunde, ein Prüfsystem für digitale Schaltungen zu schaffen, bei dem mit einfachen Mitteln eine optimierte bus- und bausteinspezifische Prüfung durchgeführt werden kann.

Zur Lösung dieser Aufgabe weist ein Prüfsystem der eingangs genannten Art die Merkmale des Kennzeichens des Anspruchs 1 auf.

Das erfindungsgemäße Prüfsystem ist vorteilhaft, da getrennte Programmierbarkeit für das Busprotokoll und die bausteinspezifische Datenerzeugung eine erhebliche Reduzierung der benötigten Prüfdatensätze möglich machen. Die Anzahl der Prüfdatensätze wird somit gleich der Anzahl der Busse plus der Anzahl der Bausteine, da pro Baustein und pro Bus jeweils ein Datensatz erstellt werden muß. Der jeweilige Prüfdatensatz des Bausteins und der Datensatz des Busses werden erst beim Ablauf der Prüfung zusammengesetzt, dadurch ist die Menge der zu speichernden Daten erheblich geringer als bei bisherigen Verfahren.

Mit den erfindungsgemäßen Ausgestaltungen des Prüfsystems nach den Unteransprüchen ist eine Datenerzeugung linear oder nach programmierbaren Algorithmen und damit eine Erzeugung großer Datenmengen durch wenige Befehle möglich, und es ist durch eine Zwischenspeicherung der erzeugten Prüfdatensätze ein Echtzeitbetrieb auf dem Bus erreichbar.

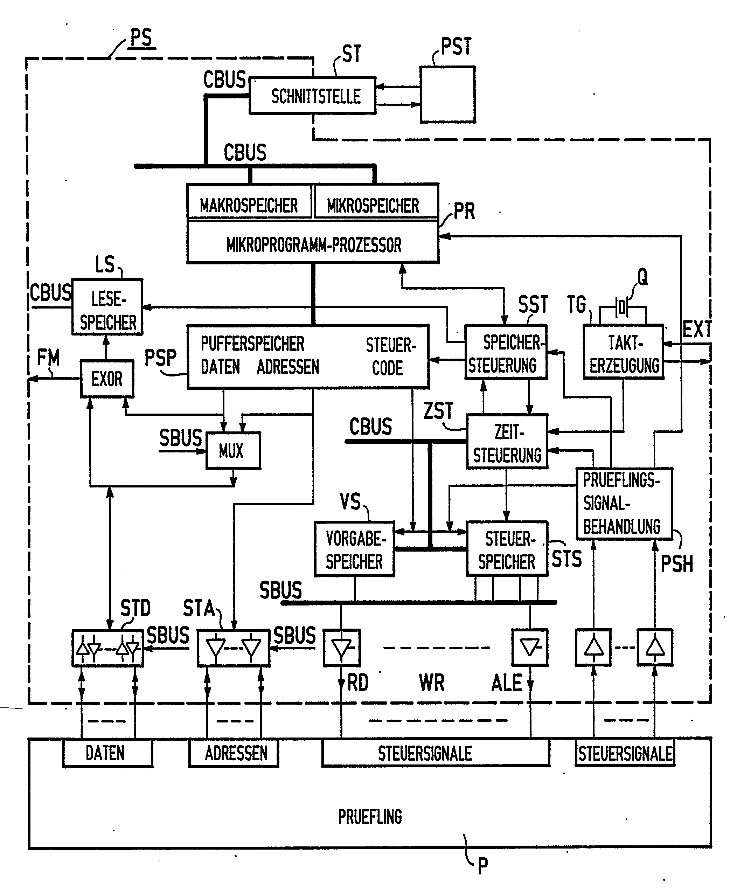

Die Erfindung wird anhand der Figur erläutert, die ein Blockschaltbild eines Ausführungsbeispiels des Prüfsystems zeigt.

Ein Prüfsystem PS erhält von einer übergeordneten Prüfsteuerung PST und einer entsprechenden Schnittstelle ST die Prüfaufträge und liefert die Prüfergebnisse an diese Prüfsteuerung PST ab. Hinter der Schnittstelle ST befindet sich ein Kommunikationsbus CBUS, der einen mikroprogrammierbaren Prozessor PR mit einem Mikroprogramm beaufschlagt. In einem Makrospeicher des Prozessors PR steht das Prozessorprogramm, welches Daten, Adressen und einen Steuercode erzeugt. Die erzeugten Daten, Adressen und der Steuercode werden in einem Pufferspeicher PSP zwischengespeichert. Der Pufferspeicher PSP steht mit einer Speichersteuerung SST in Verbindung, welche wiederum über eine Zeitsteuerung ZST gesteuert wird. Die Takterzeugung für die Zeitsteuerung ZST erfolgt in einem Taktgenerator TG entweder mit einem angeschlossenen Quarz Q oder über eine externe Taktversorgung EXT. Es ist weiterhin ein Steuerspeicher STS vorhanden, der ebenfalls von der Zeitsteuerung ZST angesteuert wird, in dem die Steuerinformationen zur Behandlung der Prüfdatensätze im Pufferspeicher PSP vorhanden sind. Weiterhin sind im Steuerspeicher Steuerinformationen vorhanden, mit denen der Prüfling direkt beaufschlagt wird. Der Steuerspeicher STS ist noch über den Kommunikationsbus CBUS und weitere Steuerleitungen mit einem Vorgabespeicher VS verbunden, der noch Informationen über Zustände von Steuerpins enthält, wenn die Steuerinformation nicht wirksam werden soll. Am Ausgang des Steuerspeichers STS ist weiterhin ein Steuerbus SBUS angeschlossen, über den aus dem Steuerspeicher STS ausgelesene Steuersequenzen bzw. Steuersignale, wie beispielsweise RD (Read), WR (Write), ALE (Adresse setzen) usw., auf eine angeschlossene zu prüfende Digitalschaltung P durchgeschaltet werden. Über den Steuerbus SBUS werden darüber hinaus auch interne Steuersignale zur Durchschaltung der Daten und Adressen, beispielsweise über einen Multiplexer MUX, weitergeleitet.

Die Prüfdatensätze aus dem Pufferspeicher PSP werden - gesteuert von der Speichersteuerung SST über jeweils eine Datenschnittstelle STD und eine Adressenschnittstelle STA - auf die zu prüfende Digitalschaltung P geleitet, wobei die Daten über den schon erwähnten Multiplexer MUX - gesteuert vom Steuerbus SBUS - geführt sind, damit eine gemeinsame Übertragung von Daten und Adressen über eine Schnittstelle möglich ist. Es wird also zunächst der Steuerspeicher STS und dann der Vorgabe-und der Pufferspeicher VS, PSP über die Zeit-und Speichersteuerung ZST, SST so ausgelesen, daß an der Schnittstelle zwischen dem Prüfsystem PS und der zu prüfenden Digitalschaltung P das Busprotokoll mit den jeweils aktuellen Daten und Adressen ansteht.

Die auszuwertenden Steuerreaktionen der zu prüfenden Digitalschaltung P werden über eine Prüflingssignalbehandlungsschaltung PSH geführt und ausgewertet. Die Ergebnisse dieser Auswertung führen zu entsprechenden Steuerreaktionen auf dem Steuerspeicher STS, der Zeitsteuerung ZST, der Speichersteuerung SST sowie auf dem Prozessor PR. Die auszuwertenden Antwortdatensätze der zu prüfenden Digitalschaltung P, die über die Datenschnittstelle STD kommen, werden mit den Referenzdaten, die im Pufferspeicher PSP stehen, über eine Vergleicherschaltung EXOR ausgewertet bzw. über einen Lesespeicher LS protokolliert. Es können somit Abweichungen erkannt und über die Fehlermeldung FM signalisiert werden.

**Ansprüche**

1. Prüfsystem für digitale Schaltungen, bei dem
-Prüfdatensätze für die Bausteine und weitere Datensätze für die nach einem vorgegebenen Übertragungsverfahren arbeitenden Busleitungen der digitalen Schaltung (P) bereitgestellt werden und
-ein Vergleich der Antwortdatensätze der Bausteine mit entsprechenden Referenzdatensätzen vorgenommen wird, **dadurch gekennzeichnet,**
-daß für jeden Baustein und für jeden Bus der zu prüfenden digitalen Schaltung (P) ein spezifischer Prüfdatensatz bzw. ein weiterer Datensatz bereitgestellt wird
-und daß während des Ablaufs einer vollständigen Prüfsequenz die bus-und bausteinspezifischen Datensätze derart miteinander kombiniert werden, daß das jeweils busspezifische Protokoll entsteht.

2. Prüfsystem nach Anspruch 1, **dadurch gekennzeichnet,**
-daß ein Pufferspeicher (PSP) vorhanden ist, in dem die von einem Prozessor (PR) erzeugten Prüfdatensätze zwischengespeichert werden,
-daß ein Steuerspeicher (STS) vorhanden ist, in dem die Steuersequenzen zur Aufschaltung der Steuersignale zur zu prüfenden Schaltung (P) und für interne Steuerzwecke gespeichert sind,
-und daß eine Speicher-(SST) und eine Zeitsteuerung (ZST) vorhanden ist, mit der der Pufferspeicher (PSP) und der Steuerspeicher (STS) so ausgelesen werden, daß an der Schnittstelle zur zu prüfenden digitalen Schaltung die aktuellen Prüfdatensätze im jeweiligen busspezifischen Protokoll bereitstehen.

3. Prüfsystem nach Anspruch 1, **dadurch gekennzeichnet,**
-daß ein Pufferspeicher (PSP) vorhanden ist, in den die von einer Prüfsteuerung (PST) gelieferten Prüfdatensätze eingelesen werden,
-daß ein Steuerspeicher (STS) vorhanden ist, in dem die Steuersequenzen zur Aufschaltung der Steuersignale zur zu prüfenden Schaltung (P) und für interne Steuerzwecke gespeichert sind,
-und daß eine Speicher-(SST) und eine Zeitsteuerung (ZST) vorhanden ist, mit der der Pufferspeicher (PSP) und der Steuerspeicher (STS) so ausgelesen werden, daß an der Schnittstelle zur zu prüfenden digitalen Schaltung die aktuellen Prüfdatensätze im jeweiligen busspezifischen Protokoll bereitstehen.

4. Prüfsystem nach Anspruch 2 oder 3, **dadurch gekennzeichnet,**
-daß die Kombination der Prüfdatensätze nach einem im Prozessor (PR) abgelegten programmierbaren Algorithmus erfolgt.

5. Prüfsystem nach Anspruch 2 oder 3, **dadurch gekennzeichnet,**
-daß die Kombination der Datensätze linear beim Auslesen des Pufferspeichers (PSP) und des Steuerspeichers (STS) erfolgt.

# EUROPÄISCHER RECHERCHENBERICHT

**Europäisches Patentamt**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 042 222 (ZEHNTEL) * Zusammenfassung; Seite 1, Zeile 30 - Seite 5, Zeile 32; Figur 1 * | 1-5 | G 06 F 11/26 G 01 R 31/28 |
| A | GB-A-2 108 277 (TERADYNE) * Zusammenfassung; Seite 1, Zeilen 29-119; Figur 1; Anspruch 1 * | 1-5 | |
| A | GB-A-2 059 122 (HONEYWELL INFORMATION SYSTEMS) * Zusammenfassung; Seite 1, Zeile 85 - Seite 2, Zeile 94; Figur 1 * | 1-5 | |
| A | GB-A-2 144 228 (INSTRUMENTATION ENGINEERING INC.) * Zusammenfassung; Seite 1, Zeile 121 - Seite 2, Zeile 50; Figur 1 * | 1-5 | **RECHERCHIERTE SACHGEBIETE (Int. Cl.4)** |
| A | FR-A-2 385 148 (THE BENDIX CORP.) * Seite 1, Zeilen 25-28; Seite 2, Zeilen 15-20; Seite 3, Zeile 10 - Seite 4, Zeile 10; Ansprüche 1,3; Figur 1 * | 1-5 | G 06 F G 01 R |

Der vorliegende Recherchenbericht wurde für alle Patentansprüche erstellt.

| Recherchenort | Abschlußdatum der Recherche | Prüfer |
|---|---|---|
| DEN HAAG | 10-11-1987 | WEBER, V.G.E. |